# EUROPEAN PATENT SPECIFICATION

(11) **EP 0 484 062 B1**
(45) Date of publication and mention of the grant of the patent: **05.07.1995**
(21) Application number: 91309879.4
(22) Date of filing: 25.10.1991
(51) Int. Cl.: H01L 25/10, H01L 23/495

(54) **A semiconductor device comprising two integrated circuit packages**
Eine Halbleiteranordnung mit zwei integrierten Schaltungspackungen
Un dispositif semiconducteur comprenant deux empaquetages de circuit intégré

(30) Priority: 30.10.1990 JP 296638/90
(43) Date of publication of application: 06.05.1992
(73) Proprietor: MITSUBISHI DENKI KABUSHIKI KAISHA, Tokyo (JP)
(72) Inventor: Uemura, Syuniti, c/o Mitsubishi Denki K. K., Itami-shi, Hyogo-ken (JP); Murasawa, Yasuhiro, c/o Mitsubishi Denki K. K., Itami-shi, Hyogo-ken (JP); MAEDA, Hajime, Itami-shi, Hyogo-ken (JP)
(74) Representative: Beresford, Keith Denis Lewis

(56) References cited:
- GB-A- 2 145 561
- US-A- 4 994 896
- PATENT ABSTRACTS OF JAPAN vol. 11, no. 92 (E-491)(2539) 24 March 1987 & JP-A-61 244 054
- PATENT ABSTRACTS OF JAPAN vol. 10, no. 46 (E-383)(2103) 22 February 1986 & JP-A-60 200 559
- Multichip Modules, ed. by R.Wayne Johnson et al.,IEEE press.

## Description

### FIELD OF THE INVENTION

The present invention relates to a semiconductor device which is formed by mounting semiconductor packages having integrated circuits on a package substrate.

### BACKGROUND OF THE INVENTION

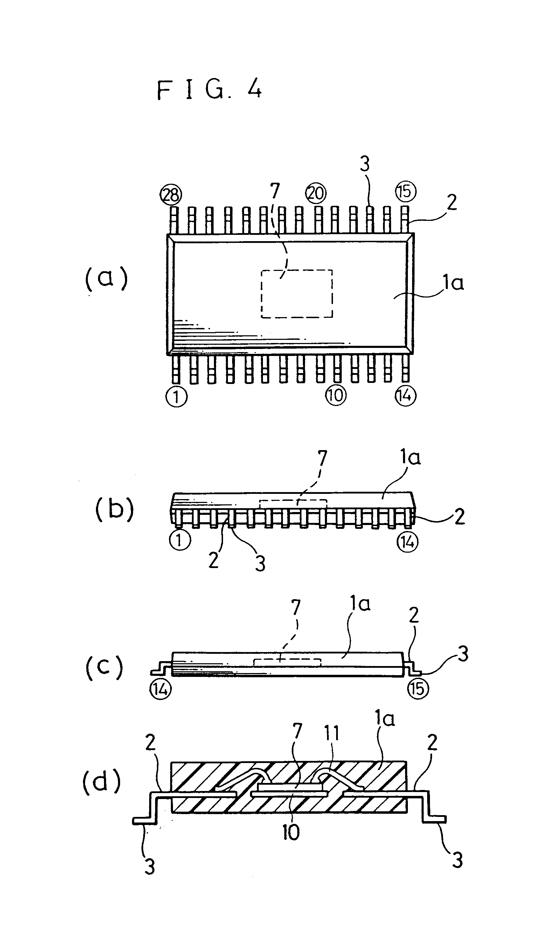

Figure 4(a) is a plan view showing an IC package having external lead terminals which are downwardly bent with respect to a plane surface of the package (hereinafter referred to as an A-type IC package). Figures 4(b) to 4(d) are a side elevational view, a front elevational view, and a sectional view, respectively, of the A-type IC package. Here, a small outline package (SOP) is employed. As shown in figure 4(d), an IC chip 7 disposed on a die pad 10 is electrically connected with external lead terminals 2 by bonding wires 11. The die pad 10, the IC chip 7, parts of the external lead terminals 2 and the bonding wires 11 are packaged by mold plastic to produce the A-type IC package l a.

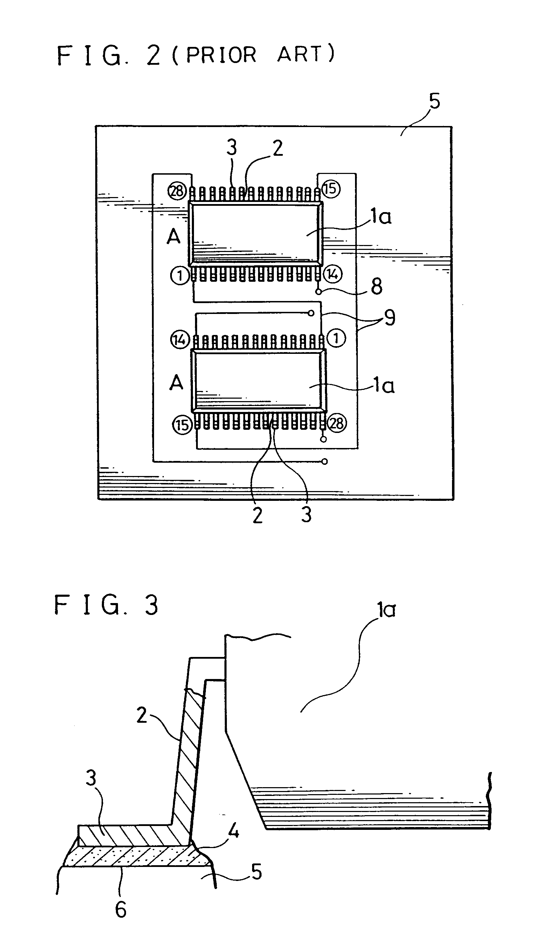

Figure 2 is a plan view showing a prior art semiconductor device, in which a pair of A-type IC packages are mounted on one side of a package substrate. In figure 2, the A-type packages 1 a are mounted on the package substrate 5. Soldering portions 3 of the external lead terminals 2 are connected to the package substrate 5 by solder, and thus the A-type packages 1a are fixed onto the package substrate 5. The A-type packages la are connected with each other by wires 9 and through holes 8. The external lead terminals 2 have pin numbers of (d)- @ , respectively.

Description is given of a method for mounting the A-type IC package la on the package substrate 5. Figure 3 is an enlarged sectional view of a lead connection part of the A-type IC package. First, solder 4 is previously applied to a mount pad 6 of each electrode portion formed on the surface of the package substrate 5. Then the package 1a is mounted on the package substrate 5 by that the soldering portion 3 of the external lead terminal 2 is soldered to the mount pad 6 by the solder 4 to be electrically and mechanically connected to the same.

In order to obtain a construction in which two A-type packages la are mounted on the substrate 5 and the external lead terminals 2 of the packages having the same numbers of pins are mutually connected with each other as shown in figure 2, it is necessary to provide wires 9 of complicated arrangements and also to provide through holes 8 penetrating the package substrate 5.

As described above, in this prior art semiconductor device, a pair of A-type packages are mounted on one surface of the package substrate and the external lead terminals of the packages having the same numbers of pins are connected with each other as shown in figure 2. Then, wires 9 inevitably intersect with each other and wires 9 of complicated arrangements are provided. Further, the through holes must be provided penetrating through the package substrate 5.

One approach to this problem is described in Japanese Kokai 63296292. As disclosed therein, packages having upwardly and downwardly bent external lead terminals, respectively, are arranged in parallel with corresponding terminals opposite one another. The respective mount pads to which oppositely aligned external lead terminals are connected are interconnected by non-intersecting single wires.

The present invention is intended to provide a semiconductor device in which external lead terminals of two packages, which are to be electrically connected with each other and which have the same numbers of pins arranged symmetrically with each other, are connected on the same mount pads with no intersection of wires and no necessity of providing through holes, in a single-surface mounting of IC packages.

Other advantages of the present invention will become apparent from the detailed description given hereinafter.

In accordance with claim 1 of the present invention, there is provided a semiconductor device comprising:
a package substrate;
a first IC package having external lead terminals which are downwardly bent with respect to a plane surface of the package and a second IC package having external lead terminals which are upwardly bent with respect to a plane surface of the package, which are provided on one surface of said package substrate and arranged in parallel with each other;

which semiconductor device is characterised in that:
one or more pairs of said external lead terminals of said first and second IC packages, which face each other and are electrically connected with each other, are arranged on the same respective mount pads provided on said package substrate; and
said external lead terminals of said first and second packages which are electrically connected with each other on the same respective mount pads are arranged such that the external lead terminals of either package are located between the external terminals of the other package.

Wires having a complicated arrangement and through holes can be dispensed with. In addition, since the external lead terminals of the two packages are arranged such that the external lead terminals of either package are arranged between those of the other package, high density mounting can be achieved.

### BRIEF DESCRIPTION OF THE DRAWINGS

Figure 1 is a plan view showing a semiconductor device on which IC packages are mounted in accordance with an embodiment of the present invention;
Figure 2 is a plan view showing a semiconductor device on which IC packages are mounted in accordance with the prior art;
Figure 3 is an enlarged sectional view of a lead connection part of the IC package shown in figure 2;
Figures 4(a) to 4(d) are a plan view, a side elevational view, a front elevational view, and a sectional view, respectively, of an A-type IC package;
Figures 5(a) to 5(d) are a plan view, a side elevational view, a front elevational view, and a sectional view, respectively, of a B-type IC package; and
Figure 6 is a diagram showing the relationship between a mount pad and external leads.

### DETAILED DESCRIPTION OF THE PREFERRED EMBODIMENTS

An embodiment of the present invention will be described in detail with reference to the drawings.

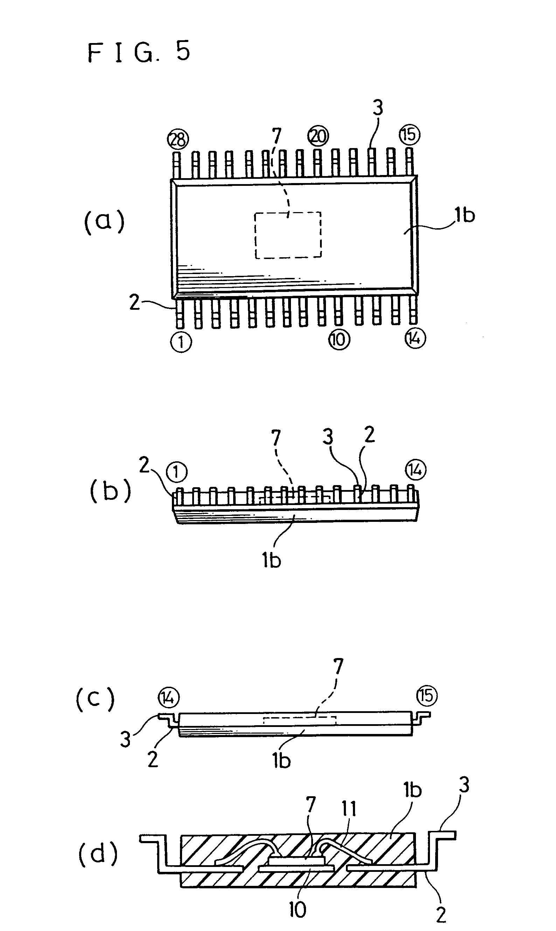

Figure 5(a) is a plan view showing an IC package having external lead terminals 2 which are upwardly bent with respect to a plane surface of the package (hereinafter referred to as a B-type package). Figures 5(b) to 5(d) are a side elevational view, a front elevational view, and a sectional view, respectively, of the B-type package. This B-type package is different from the aforementioned A-type package only in the manner of bending of the external lead terminals.

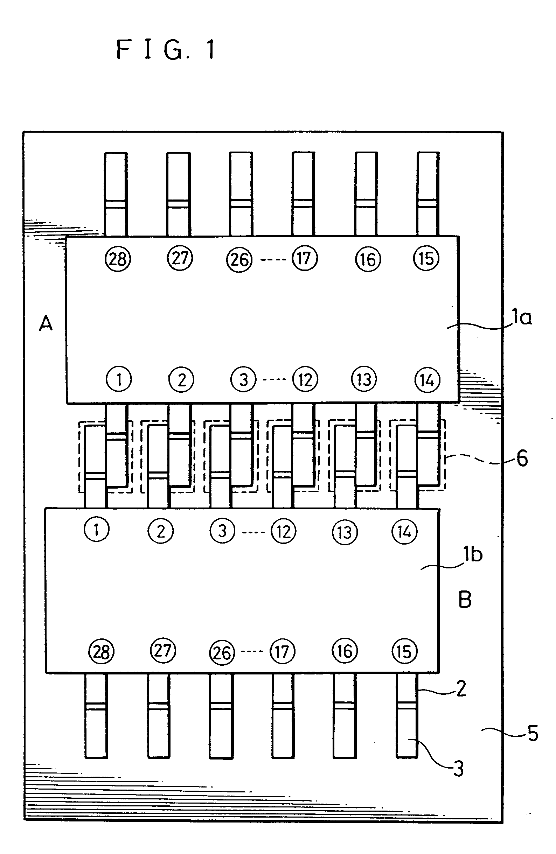

Figure 1 is a plan view showing a semiconductor device in accordance with an embodiment of the present invention. In figure 1, the A-type IC package la and the B-type IC package Ib are mounted on the package substrate 5. External lead terminals 2 of the respective packages 1a a and 1 b are designated by pin numbers ① to 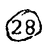 .

As described above, the A-type package la and the B- type package 1 b are different from each other only in the manner of bending of the external lead terminals.

Therefore, when the A-type package la and the B-type package 1 b are arranged in approximately parallel with each other on the substrate 5 as shown in figure 1, the lead terminals 2 ofthe A-type package la having pin numbers of ① to 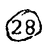 are arranged in positions line symmetrical (in a relation of mirror image) with positions of the external lead terminals 2 of the B-type package 1 b having the same pin numbers.

Description is given of the function and effect hereinafter.

In this embodiment, two kinds of packages, i.e., the A-type package 1a and the B-type package 1 b, are mounted on the package substrate 5 unlike the conventional one.

In a case of single-surface mounting, the A-type and B-type packages 1 a and 1 b are mounted on one surface of the package substrate 5 as shown in figure 1. In this case, external lead terminals 2 of the package la are arranged in positions line symmetrical (in a relation of mirror image) with positions of the external lead terminals 2 of the package 1 b having the same pin numbers. Therefore, the external lead terminals facing to each other, i.e., those of pin numbers to can be arranged on the same mount pads 6, so that wires can be dispensed with. In addition, other external lead terminals, i.e., external lead terminals of pin numbers 15 to 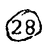 , can be electrically connected with those of the other package simply by drawing around wires without necessity of providing through holes.

In the above embodiment of figure 1, since the external lead terminals 2 of the B-type package 1 b are arranged between those of the A-type package 1a, the soldering portions 3 of the external lead terminals 2 of respective packages 1a a and 1 b having the same pin numbers can be arranged on the same mount pads without drawing around wires. In addition to the above-described effects, the area of the substrate on which these packages are mounted can be reduced, resulting in high-density mounting.

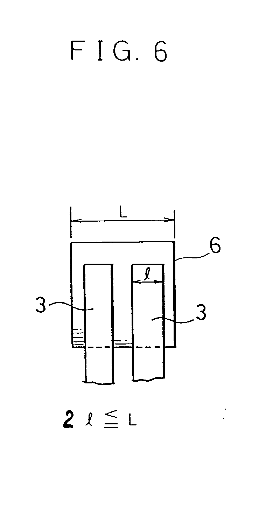

The relationship between portions 3 of the external lead terminals 2 (hereinafter referred to simply as leads 3) and the mount pad is illustrated in figure 6.

The mount pad 6 is fundamentally a conductor used for connection or installation of element parts. Now suppose that the width of each lead is f and the width of the member connecting two leads (mount pad) is L, then if 2ℓ ≦ L, it can be said that the two leads 3 are mounted on the same mount pad 6.

As described above, in the above-described embodiment, the A-type package having external lead terminals downwardly bent and the B-type package having external lead terminals upwardly bent are mounted on the package substrate and the external lead terminals of both packages are located in positions line symmetrical with each other, so that the external lead terminals facing each other can be electrically connected on the same mount pads. Therefore, there is no necessity of providing wires for connecting those lead terminals and the other external lead terminals can also be connected by simply drawing around wires without providing through holes. In addition, no positional deviation between the two packages occurs and no solder bridge of the leads owing to a complicated soldering occurs.

While in the above embodiment small outline packages are described, the present invention can also be applied to a plastic leaded chip carrier (PLCC) having external lead terminals formed into J-shape or a J lead type small outline package having J-shaped leads. Thus, the present invention is applicable to all surface-mounting type packages.

While in the above embodiment pin numbers are allotted to the external lead terminals and the lead terminals having the same pin numbers are connected with each other, the pin numbers are not always necessary to be allotted if two lead terminals to be electrically connected are certainly connected with each other. In addition, all of the lead terminals are not necessary to be connected. However, at least a pair of lead terminals should be connected.

While in the above embodiment the external lead terminals are connected between two IC packages, one or more pairs of external lead terminals of the same IC package, which are adjacent to each other, can be connected on the same mount pads 6 in the manner shown in figure 6.

As is evident from the foregoing description, according to the present invention, a first IC package having external lead terminals which are downwardly bent with respect to a plane surface of the package and a second IC package having external lead terminals which are upwardly bent with respect to a plane surface of the package are mounted on a package substrate such that external lead terminals of the two packages having the same pin numbers are arranged in positions line symmetrical with each other, and the external lead terminals facing to each other are connected on the same mount pads. Therefore, the amount of wires to be provided on the substrate can be largely reduced. In addition, external lead terminals other than those which are mutually connected with each other as described above can also be electrically connected by simply drawing around wires, without occurring intersections of wires and without providing through holes.

## Claims

1. A semiconductor device comprising:
a package substrate (5);
a first IC package (1a) having external lead terminals (2) which are downwardly bent with respect to the plane surface of the package and a second IC package (1 b) having external lead terminals (2) which are upwardly bent with respect to the plane surface of the package, said first and second IC packages are provided on one surface of said package substrate (5) and arranged in parallel with each other;
said semiconductor device is characterised in that:
one or more pairs of said external lead terminals (2), a pair being formed by one external lead terminal of the first IC package (1 a) and one external terminal of the second IC package (1 b), said external terminals (2) face each other and are electrically connected with each other, are arranged on the same respective mount pads (6) provided on said package substrate (5); and
said external lead terminals (2) of said first and second packages (1a,1b) which are electrically connected with each other on the same respective mount pads (6) are arranged such that the external lead terminals (2) of either package (1a, 1b) are located between the external terminals (2) of the other package (1b, 1a).

## Patentansprüche

1. Halbleiteranordnung, mit:
einem Gehäuse-Substrat (5);
einem ersten IC-Gehäuse (1a) mit externen Anschlußklemmen (2), die mit Bezug auf die ebene Oberfläche des Gehäuses nach unten gebogen sind, und
einem zweiten IC-Gehäuse (1 b) mit externen Anschlußklemmen (2), die mit Bezug auf die ebene Oberfläche des Gehäuses nach oben gebogen sind,
wobei das erste und das zweite IC-Gehäuse auf einer Oberfläche des Gehäuse-Substrats (5) und parallel zueinander angeordnet sind;
wobei die Halbleiteranordnung dadurch gekennzeichnet ist, daß:
ein oder mehrere Paare der externen Anschlußklemmen (2), wobei ein Paar von einer externen Anschlußklemme des ersten IC-Gehäuses (1a) und einerexternen Anschlußklemme des zweiten IC-Gehäuses (1 b) gebildet wird, wobei die externen Anschlußklemmen (2) einander gegenüberliegen und elektrisch miteinander verbunden sind, auf der auf dem Gehäuse-Substrat (5) vorgesehenen selben jeweiligen Befestigungs-Anschlußfläche (6) angeordnet sind; und
die auf der gleichen jeweiligen Befestigungs-Anschlußfläche (6) elektrisch miteinander verbundenen externen Anschlußklemmen (2) des ersten und zweiten Gehäuses (1 a, 1 b) derart angeordnet sind, daß die externen Anschlußklemmen (2) jedes Gehäuses (1a, 1b) zwischen den externen Anschlußklemmen (2) des anderen Gehäuses (1 b, 1a) angeordnet sind.

## Revendications

1. Un dispositif à semiconducteurs comprenant :
un substrat de boîtiers (5) ;
un premier boîtier de circuit intégré (1a) ayant des bornes de connexion externes (2) qui sont courbées vers le bas par rapport à la surface plane du boîtier, et un second boîtier de circuit intégré (1 b) ayant des broches de connexion externes (2) qui sont courbées vers le haut par rapport à la surface plane du boîtier, ces premier et second boîtiers de circuit intégré étant placés sur une surface du substrat de boîtiers (5) et disposés parallèlement l'un à l'autre ;
ce dispositif à semiconducteurs étant caractérisé en ce que :
une ou plusieurs paires des bornes de connexion externes (2), une paire étant formée par une borne de connexion externe du premier boîtier de circuit intégré (1a) et une borne de connexion externe du second boîtier de circuit intégré (1b), ces bornes externes (2) étant disposées face à face et étant connectées électriquement l'une à l'autre, sont disposées sur les mêmes plots de montage respectifs (6) formés sur le substrat de boîtiers (5) ; et
les bornes de connexion externes (2) des premier et second boîtiers (1a, 1b) qui sont connectées électriquement ensemble sur les mêmes plots de montage respectifs (6), sont disposées de façon que les bornes de connexion externes (2) de chaque boîtier (1 a, 1 b) soient placées entre les bornes externes (2) de l'autre boîtier (1 b, 1 a).
